# EUROPÄISCHE PATENTSCHRIFT

(11) **EP 0 923 136 B1**
(45) Veröffentlichungstag und Bekanntmachung des Hinweises auf die Patenterteilung: **02.07.2008**
(21) Anmeldenummer: 98810788.4
(22) Anmeldetag: 17.08.1998
(51) Int. Cl.: H01L 29/744, H01L 29/06

(54) **Abschaltthyristor mit Stopschicht**
Gate turn off thyristor with stop layer
Thyristor blocable avec couche d'arrêt

(30) Priorität: 24.10.1997 DE 19746974
(43) Veröffentlichungstag der Anmeldung: 16.06.1999
(73) Patentinhaber: ABB Schweiz AG, 5400 Baden (CH)
(72) Erfinder: Linder, Stefan, Dr., 4800 Zofingen (CH); Weber, André, Dr., 4600 Olten (CH)
(74) Vertreter: ABB Patent Attorneys

(56) Entgegenhaltungen:
- EP-A- 0 061 046
- EP-A- 0 666 601
- EP-A- 0 700 095
- JP-A- 60 154 564
- PATENT ABSTRACTS OF JAPAN vol. 11, no. 169 (E-511), 30. Mai 1987 (1987-05-30) & JP 62 001273 A (FUJI ELECTRIC CO LTD), 7. Januar 1987 (1987-01-07)

## Beschreibung

### Technisches Gebiet

Die Erfindung bezieht sich auf das Gebiet der Leistungshalbleitertechnologie. Sie geht aus von einem Abschaltthyristor oder GTO gemäss dem Oberbegriff des ersten Anspruchs.

### Stand der Technik

Ein solcher GTO umfasst im wesentlichen eine npnp Vierschichtstruktur sowie eine anodenseitige Stopschicht und wird zum Beispiel in der Deutschen Offenlegungsschriften DE 43 13 170 A1 beschrieben. Weitere GTOs mit Stopschicht sind aus dem US Patent US 5,028,974 und der DE 44 31 294 A1 bekannt.

Abschaltbare Thyristoren mit Stoppschicht und homogenem Anodenemitter mit geringer fizienz, wie zum Beispiel in der genannten DE 43 13 170 A1 offenbart, werden üblicherweise mit ganzflächiger Stopschicht und ganzflächigem Anodenemitter hergestellt. Im blockierenden Zustand fliesst dann ein gewisser Sperrstrom zwischen Anode und Gate eines solchen Elementes. In der Raumladungszone werden Ladungsträger erzeugt. Die so entstandenen Löcher fliessen durch den Gateanschluss ab, die Elektronen durch die Anode. Bei ganzflächiger Ausführung von Stopschicht und Anodenemitter stellt der sperrende GTO somit einen Transistor mit offener Basis dar. Die durch die Anode abfliessenden Elektronen führen zu einem Spannungsabfall am Anodenemitter. Dies wiederum führt zu einer Injektion von Löchern. Dadurch wird der in der Raumladungszone generierte Sperrstrom zusätzlich verstärkt.

Der Sperrstrom führt zu einer Erwärmung des GTOs. Im Bereich des Randabschlusses ist die Kühlung der Siliziumscheibe aber reduziert. Dadurch kann es in diesem Bereich zu einem unkontrollierten Anstieg der Temperatur kommen. Dies führt zu einem weiteren Anstieg des Sperrstromes. Insgesamt kann die beschriebene Problematik zu einem thermischen Weglaufen und schlimmstenfalls zu einer Zerstörung des Elementes führen.

Das Dokument JP 62-1273 gibt ein Halbleitermodul an, bei dem im selben Halbleitersubstrat ein GTO Thyristor und eine Diode angeordnet sind. Die p-Basisschicht weist im Bereich der Diode eine dünnere, gleichförmige Schichtdicke als im Bereich des GTO's auf.

JP 60-154564 zeigt einen GTO mit hoher Überschlagsspannung, welcher randseitig einen Bereich ohne elektrische Kontaktierungen aufweist und kathodenseitig abgeschrägt ist. Der GTO weist keine Stoppschicht auf.

### Darstellung der Erfindung

Aufgabe der Erfindung ist es deshalb, einen Abschaltthyristor (GTO) anzugeben, der insbesondere in seinem Randabschlussgebiet thermisch stabil ist und in jedem Betriebszustand sicher betrieben werden kann. Diese Aufgabe wird durch die Merkmale des unabhängigen Anspruchs gelöst.

Kern der Erfindung ist es also, im Bereich des Randabschlusses Mittel vorgesehen sind, die die Stopschicht mit der Anode verbinden. Dadurch weist der GTO im sperrenden Zustand im Randbereich die Struktur einer Diode auf, und die eingangs beschriebene Verstärkung des Sperrstromes fällt weg. Die thermische Belastung im Randbereich wird reduziert, und das Bauelement erträgt bei vorgegebener Spannung eine höhere Betriebstemperatur.

Ein erstes Ausführungsbeispiel ist dadurch gekennzeichnet, dass im Bereich des Randabschlusses ein Kurzschlussgebiet vorgesehen ist, das mit der Anode verbunden ist und die Stopschicht mit der Anode kurzschliesst. In einem zweiten Ausführungsbeispiel ist der Anodenemitter nicht ganzflächig ausgebildet, sondern er wird im Bereich des Randabschlusses durch die mit der Anode verbundene Stopschicht ersetzt.

### Kurze Beschreibung der Zeichnungen

Nachfolgend wird die Erfindung anhand von Ausführungsbeispielen im Zusammenhang mit den Zeichnungen näher erläutert.

Es zeigen:
- **Fig. 1**: Ein GTO mit anodenseitiger Stopschicht nach dem Stand der Technik;
- **Fig. 2**: Ein erfindungsgemässer GTO nach einem ersten Ausführungsbeispiel;
- **Fig. 3**: Ein erfindungsgemässer GTO nach einem zweiten Ausführungsbeispiel.

Die in den Zeichnungen verwendeten Bezugszeichen und deren Bedeutung sind in der Bezugszeichenliste zusammengefasst aufgelistet. Grundsätzlich sind in den Figuren gleiche Teile mit gleichen Bezugszeichen versehen.

### Wege zur Ausführung der Erfindung

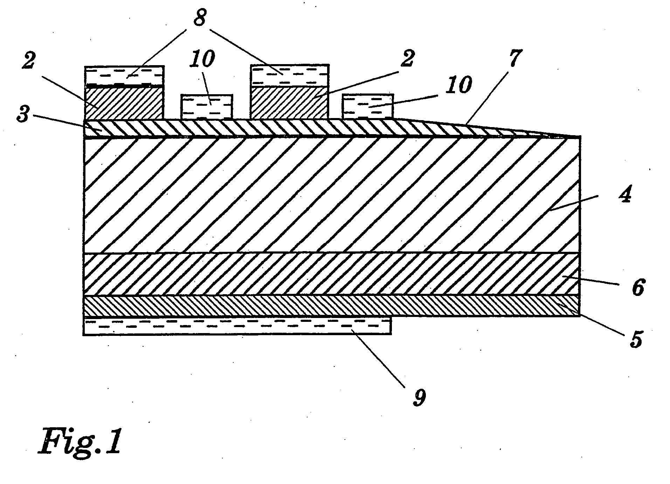

In Figur 1 ist ein Ausschnitt eines Abschaltthyristors oder GTOs nach dem Stand der Technik dargestellt. In einem Halbleiterkörper 1 ist eine Anzahl von unterschiedlich dotierten Schichten, die im wesentlichen eine npnp-Thyristorstruktur bilden, angeordnet. N-dotierte Gebiete sind mit von oben rechts nach unten links verlaufenden Linien schraffiert, p-dotierte Gebiete mit von oben links nach unten rechts verlaufenden Linien und Metallisierungen mit waagrechten kurzen Strichen. Die Dichte der Schraffur kann als Hinweis auf die Dotierungsstärke verstanden werden. Von einer anodenseitigen Hauptfläche her folgen ein p+ dotierter Anodenemitter 5, eine n dotierte Stopschicht 6, eine n- dotierte n-Basis 4, eine p dotierte p-Basis 3 und n+ dotierte Kathodenemittergebiete 2. Die letzteren werden von einer eine Kathode 8 bildenden Metallisierung kontaktiert. Die Kathodenemittergebiete 2 können wie dargestellt erhaben oder aber auch in die p-Basis 3 integriert ausgeführt sein. Zwischen den Kathodenemittergebieten 2 wird die p-Basis 3 von einer ein Gate 10 bildenden Metallisierungen kontaktiert. Um Feldüberhöhungen am Rand des GTO zu vermeiden und das Bauelement sicher für hohe Spannungen zu machen ist randseitig ein sog. Randabschlussgebiet 7 vorgesehen. Wie in der Figur gezeigt, weist das Randabschlussgebiet kathodenseitig keine elektrische Kontaktierung auf. In diesem Bereich sind keine Kathodenemitter 2 mehr vorhanden und die Halbleiterscheibe kann insbesondere abgeschrägt sein.

Solche Abschaltthyristoren mit einer Stopschicht 6 und einem homogenen Anodenemitter 5 werden heute hergestellt mit einer ganzflächigen Stopschicht 6 und einem ganzflächigem Anodenemitter 5. Vorzugsweise weist der Anodenemitter 5 ausserdem eine geringe Effizienz auf. Im blockierenden Zustand fliesst dann ein gewisser Sperrstrom zwischen Anode und Gate eines solchen Elementes. In der Raumladungszone werden Ladungsträger erzeugt. Die so entstandenen Löcher fliessen durch den Gateanschluss ab, die Elektronen durch die Anode. Bei ganzflächiger Ausführung von Stopschicht und Anodenemitter stellt der sperrende GTO somit einen Transistor mit offener Basis dar. Die durch die Anode abfliessenden Elektronen führen zu einem Spannungsabfall am Anodenemitter. Dies wiederum führt zu einer Injektion von Löchern. Dadurch wird der in der Raumladungszone generierte Sperrstrom zusätzlich verstärkt.

Der Sperrstrom führt zu einer Erwärmung des GTOs. Im Bereich des Randabschlusses ist die Kühlung der Siliziumscheibe aber reduziert. Dadurch kann es in diesem Bereich zu einem unkontrollierten Anstieg der Temperatur kommen. Dies führt zu einem weiteren Anstieg des Sperrstromes. Insgesamt kann die beschriebene Problematik zu einem thermischen Weglaufen und schlimmstenfalls zu einer Zerstörung des Elementes führen.

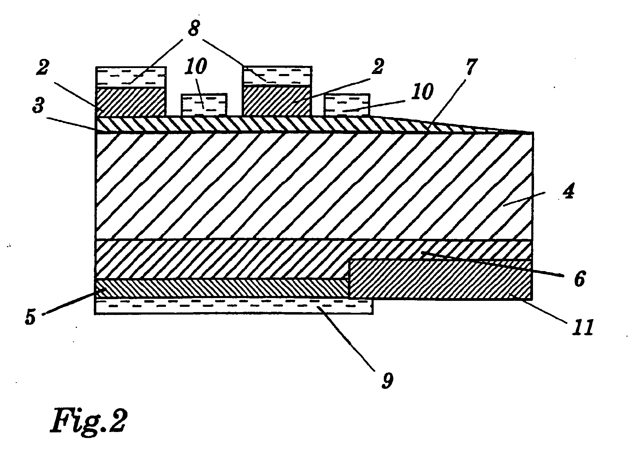

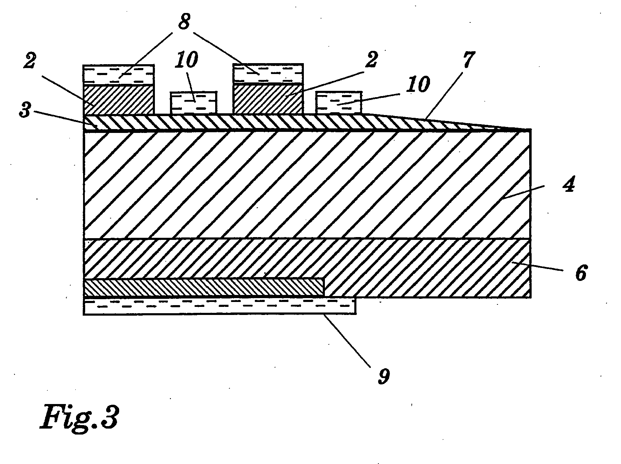

Nach Figur 2 und 3 werden deshalb nach der Erfindung im Bereich des Randabschlusses Mittel vorgesehen, die die Stopschicht mit der Anode verbinden. Gemäss dem Ausführungsbeispiel nach Figur 2 umfassen die Mittel einen Kurzschlussgebiet 11, das mit der Stopschicht 6 verbunden ist und diese mit der Anode 9 kurzschliesst. Die Dotierung des Kurzschlussgebietes 11 muss die Dotierung des Anodenemitters 5 mindestens kompensieren, d.h. das Kurzschlussgebiet wird im allgemeinen n+ dotiert sein. Die sperrende Struktur im Bereich des Randabschlusses 7 ist somit eine Diode. Dadurch entfällt in diesem Bereich die Verstärkung des Sperrstromes. Die thermische Belastung im Randbereich wird damit reduziert. Demzufolge kann die Betriebstemperatur bei vorgegebener Spannung erhöht werden.

Figur 3 zeigt eine andere Lösung. Hier wird der Anodenemitter 5 nicht ganzflächig ausgeführt, so dass die Stopschicht 6 bis zur anodenseitigen Hauptfläche dringt und von der Anode 9 kontaktiert wird. Somit wird auch hier die Stopschicht 6 mit der Anode 9 kurzgeschlossen. Der Kurzschluss kann beispielsweise gleichzeitig mit der Ausbildung des kathodenseitigen Emitters erfolgen. Insgesamt ergibt sich mit der Erfindung ein GTO, der thermisch stärker belastet werden kann, somit robuster ist und weniger Kühlung benötigt. Der erfindungsgemässe GTO ist insbesondere in seinem Randabschlussgebiet thermisch stabil und kann in jedem Betriebszustand sicher betrieben werden.

### Bezugszeichenliste

- 1: Halbleiterkörper
- 2: Kathodenemittergebiet
- 3: p-Basis
- 4: n-Basis
- 5: Anodenemitter
- 6: Stopschicht
- 7: Randabschlussgebiet
- 8: Kathode, Kathodenmetallisierung
- 9: Anode, Anodenmetallisierung
- 10: Gate
- 11: n+ Kurzschlussgebiet

## Patentansprüche

1. Abschaltthyristor (GTO) umfassend
a) in einem Halbleiterkörper (1) eine npnp-Vierschichtstruktur mit Kathodenemittergebieten (2), einer p-Basis (3), einer n-Basis (4) und einem homogenen Anodenemitter (5);
b) eine stärker als die n-Basis (4) dotierte Stopschicht (6), die zwischen der n-Basis (4) und dem Anodenemitter (5) angeordnet ist;
c) eine Kathode (8), die die Kathodenemittergebiete (2) kontaktiert, eine Anode (9), die den Anodenemitter (5) kontaktiert und ein Gate (10), das die p-Basis (3) kontaktiert;
d) ein Randabschlussgebiet (7), welches am Rand des Halbleiterkörpers (1) angeordnet ist, welches Randabschlussgebiet (7) Teile der p-Basis (3), der n-Basis (4) und der Stopschicht (6) enthält und welches Randabschlussgebiet (7) kathodenseitig keine elektrische Kontaktierung aufweist und an der kathodenseitigen Oberfläche des Halbleiterkörpers (1) eine Abschrägung aufweist;
**dadurch gekennzeichnet, dass**
e) im Bereich des Randabschlussgebietes (7) Mittel vorgesehen sind, die die Stopschicht (6) mit der Anode (9) verbinden.

2. GTO nach Anspruch 1, **dadurch gekennzeichnet, dass** im Bereich des Randabschlussgebietes (7) ein Kurzschlussgebiet (11) vorgesehen ist, das mit der Anode (9) verbunden ist und die Stopschicht (6) mit der Anode (9) kurzschliesst.

3. GTO nach Anspruch 1, **dadurch gekennzeichnet, dass** der Anodenemitter (5) nicht ganzflächig ausgebildet ist und im Bereich des Randabschlussgebietes (7) durch die mit der Anode (9) verbundene Stopschicht (6) ersetzt ist.

## Claims

1. Gate turn-off thyristor (GTO) comprising
a) in a semiconductor body (1), an npnp four-layer structure having cathode emitter regions (2), a p-type base (3), an n-type base (4) and a homogeneous anode emitter (5);
b) a stop layer (6), which is more heavily doped than the n-type base (4) and is arranged between the n-type base (4) and the anode emitter (5);
c) a cathode (8), which makes contact with the cathode emitter regions (2), an anode (9), which makes contact with the anode emitter (5), and a gate (10) which makes contact with the p-type base (3);
d) an edge termination region (7), which is arranged at the edge of the semiconductor body (1), which edge termination region (7) contains parts of the p-type base (3), of the n-type base (4) and of the stop layer (6) and which edge termination region (7) has no electrical contact-connection on the cathode side and is bevelled at the cathode side surface of the semiconductor body (1);
**characterized in that**
e) means which connect the stop layer (6) to the anode (9) are provided in the edge termination region (7).

2. GTO according to Claim 1, **characterized in that** a short-circuit zone (11), which is connected to the anode (9) and short-circuits the stop layer (6) with the anode (9), is provided in the edge termination region (7).

3. GTO according to Claim 1, **characterized in that** the anode emitter (5) is not of whole-area design and, in the edge termination region (7), is replaced by the stop layer (6) connected to the anode (9).

## Revendications

1. Thyristor de disjonction (GTO), qui comprend :
a) dans un corps semi-conducteur (1), une structure npnp en quatre couches dotée de domaines d'émetteur cathodique (2), d'une base p (3), d'une base n (4) et d'un émetteur anodique homogène (5),
b) une couche d'arrêt (6) plus fortement dopée que la base n (4) et disposée entre la base n (4) et l'émetteur anodique (5),
c) une cathode (8) en contact avec les domaines d'émetteur cathodique (2), une anode (9) en contact avec l'émetteur anodique (5) et une grille (10) en contact avec la base p (3),
d) un domaine (7) de fermeture de bord disposé sur le bord du corps semi-conducteur (1), ledit domaine (7) de fermeture de bord contenant des parties de la base p (3), de la base n (4) et de la couche d'arrêt (6), ledit domaine (7) de fermeture de bord ne présentant pas de contact électrique du côté cathodique et présentant une pente sur la surface du côté cathodique du corps semi-conducteur (1),
**caractérisé en ce que**
e) des moyens qui relient la couche d'arrêt (6) à l'anode (9) sont prévus dans la zone du domaine (7) de fermeture de bord.

2. GTO selon la revendication 1, **caractérisé en ce qu'**un domaine de court-circuit (11) qui est relié à l'anode (9) et qui met en court-circuit la couche d'arrêt (6) avec l'anode (9) est prévu dans la zone du domaine (7) de fermeture de bord.

3. GTO selon la revendication 1, **caractérisé en ce que** l'émetteur anodique (5) n'est pas réalisé sur toute la surface et est remplacé par la couche d'arrêt (6) reliée à l'anode (9) dans la zone du domaine (7) de fermeture de bord.
